Europäisches Patentamt

European Patent Office

Office européen des brevets

(19)

(11) Numéro de publication: **0 006 474**
**A1**

# DEMANDE DE BREVET EUROPEEN

(21) Numéro de dépôt: **79101707.2**

(22) Date de dépôt: **01.06.79**

(51) Int. Cl.³: **H 01 L 27/08, H 01 L 29/86**

(30) Priorité: **29.06.78 FR 7820115**

(43) Date de publication de la demande: **09.01.80**
**Bulletin 80/1**

(84) Etats contractants désignés: **DE FR GB**

(71) Demandeur: **International Business Machines
Corporation, Armonk, N.Y. 10504 (US)**

(72) Inventeur: **Baliatore, Daniel, Quartier le Figueret Pont
du Loup, F-06620 le Bar sur Loup (FR)**
Inventeur: **Delaporte, François, Le Cros Saint Pierre 19
avenue des Mimosas, F-06800 Cagnes/Mer (FR)**
Inventeur: **Lebesnerais, Gérard, 9, rue des Prés Saint-
Germain S/Ecole, 77 930-Perthes en Gatinais (FR)**
Inventeur: **Nuez, Jean-Paul, 34 avenue des
Coquelicots, F-91540 Mennecy (FR)**

(74) Mandataire: **Klein, Daniel, COMPAGNIE IBM FRANCE
Département de Propriété Industrielle, F-06610 La
Gaude (FR)**

(54) **Procédé de correction du coefficient en tension de résistances semi-conductrices diffusées ou implantées.**

(57) Procédé de correction du coefficient en tension de
résistances semi-conductrices diffusées ou implantées et
résistances ainsi obtenues. Le procédé consiste à réaliser
une électrode métallique (21), au-dessus d'une région
résistive (14) passivée par une couche diélectrique (15)
et formée dans une portion isolée électriquement de la
couche épitaxiale (12). Cette électrode métallique est reliée à un potentiel approprié, pour que le coefficient de
tension causé par la couche d'appauvrissement au voisinage de la jonction PN (20') en raison des potentiels V1
et V2 soit compensé par le coefficient de tension opposé
causé par l'effet d'enrichissement dû à la présence de
l'électrode métallique polarisée. Dans une variante, la résistance sera divisée en une pluralité de résistances élémentaires isolées les unes des autres. Application à la fabrication de résistances linéaires formées par implantation
ionique pour des circuits analogiques du type de ceux utilisés dans la commutation téléphonique.

1

# PROCEDE DE CORRECTION DU COEFFICIENT EN TENSION DE RESISTANCES SEMI-CONDUCTRICES DIFFUSEES OU IMPLANTEES

## Description

### Domaine technique

La présente invention concerne le domaine des résistances formées par implantation ionique ou par diffusion dans un substrat semi-conducteur monocristallin typiquement en silicium. Elle concerne plus particulièrement un procédé de correction du coefficient en tension (VCR) des résistances implantées et les résistances ainsi obtenues.

Le concepteur de circuits fait de plus en plus appel aux structures de circuits intégrés qui ont connu ces dernières années un développement considérable grâce aux perfectionnements apportés sans cesse aux composants actifs et/ou passifs élémentaires. A côté des composants actifs: transistors, diodes, etc. , les composants passifs, notamment, les résistances, continuent de jouer un rôle fondamental dans de nombreuses applications en particulier dans les circuits analogiques. Il y a deux façons d'associer des résistances à des composants actifs dans le domaine des circuits intégrés: d'une part la voie hybride compatible implique la mise en oeuvre de résistances déposées sous forme de films minces à la surface du bloc semi-conducteur intégré et d'autre part la voie monolithique où les résistances sont formées dans la masse du bloc semi-conducteur au même titre que les composants actifs. Dans ce dernier cas les résistances peuvent être introduites par les

2

techniques soit de diffusion thermique soit d'implantation ionique.

Les résistances diffusées sont bien connues dans la technique. Elles sont formées généralement lors du cycle de diffusion de la région base ou émetteur des transistors bipolaires. De façon classique, il s'agit de la diffusion base de type de conductivité P dans une couche épitaxiale de type $N^-$ qui recouvre un substrat en silicium monocristallin de type $P^-$. La valeur de la résistance dépend d'un certain nombre de paramètres: profil et profondeur des diffusions, rapport longueur-largeur de la zone diffusée, etc. . Deux contacts ohmiques sont établis aux extrémités de la région diffusée, et constituent les points de sortie de la résistance. La portion de la couche épitaxiale contenue dans la poche d'isolement et contenant la région résistive est en général portée au potentiel le plus positif existant sur le circuit. Ces résistances sont limitées par leur faible résistivité de feuille 400 $\Omega/\Box$, une pauvre tolérance en absolu (±20%), un fort coefficient de température de l'ordre de 2000 ppm/°C qui entraîne une variation importante de la résistance en fonction de la température: 10% entre 25 et 75°C. Cependant, le procédé de formation est d'une mise en oeuvre relativement simple et bien connu.

Les résistances implantées offrent une alternative particulièrement intéressante aux résistances diffusées et présentent des avantages importants sur les technologies concurrentes. En particulier, on peut obtenir des résistances implantées au bore ayant une faible sensibilité à la température (variation de 0,5% entre 0 et 75°C) et une large gamme de résistivité de feuille

3

(3 à 10 000 Ω/□ et même plus). Elles sont enfin relativement précises (±2%) et généralement bien appairées. Des détails sur les résistances implantées pourront être trouvés dans l'ouvrage suivant: "Ion Implanted Planar Resistors" par K. Rosendal, in Radiation Effects, Vol. 7, pages 95 à 100, janvier 1971, Nos. 1 et 2.

Une étude comparative des trois types de résistances mentionnés ci-dessus pourra être trouvée dans l'article: "The Thermal Properties of High Value Gallium and Boron Implanted Resistors in Silicon" par J. Den Boer et al, European Conference on Ion Implantation, 7-9 septembre 1970.

### Exposé du problème et description de l'art antérieur

Cependant un problème assez peu étudié jusqu'alors paraît prendre une importance croissante: il s'agit de la variation de la valeur de la résistance en fonction de la tension appliquée à ses bornes. La caractéristique courant-tension I-V d'une résistance devrait normalement être une droite. En fait ceci n'est vérifié que pour des résistances de faibles résistances de feuille, de l'ordre de quelques centaines d'ohms/□ ainsi qu'on peut s'en rendre compte dans l'article "High Value Implanted Resistors For Microcircuits" par John Mc Dougall et al, paru dans les Proceedings of the IEEE, Vol. 57, No.9, septembre 1969, page 1540 et plus particulièrement en se référant à la figure 5 dudit article. Quand on désire des résistances implantées de fortes valeurs, donc qui nécessitent des résistances de feuille élevées (par exemple 20kΩ/□), la caractéristique I-V devient non linéaire et s'incurve vers le bas, provoquant une distorsion dans la réponse de la résistance à un signal d'entrée. Ceci indique que la valeur réelle de la résistance, à une tension déterminée, est plus grande que la valeur mesurée avec une tension très faible. La caractéristique I-V est alors en tout point semblable à celle d'un transistor à effet de champ à jonction (JFET). Il est essentiel de comprendre que la valeur de la résistance est surtout fonction de la tension appliquée à la jonction formée entre la région résistive et la couche épitaxiale. Elle est donc dans une certaine mesure liée à la tension $V_R$ appliquée aux bornes de la résistance. La distorsion provient du fait que la couche d'appauvrissement, située de part et d'autre de la jonction PN et vide de porteurs de charge, tend à s'élargir avec la tension appliquée à ladite jonction le long de la résistance, réduisant la section utile de la résistance et augmentant finalement sa valeur. C'est le problème de la tension de pincement bien connu dans les JFET, mais qui est plus critique pour les résistances implantées que pour les résistances diffusées parce qu'elles sont en général de plus fortes résistivités, donc plus minces et moins dopées.

Une première solution, proposée dans l'article de John Mc Dougall précité, consiste donc à augmenter la résistivité de la couche épitaxiale, pour atteindre des valeurs supérieures à $10\Omega.cm$. Cependant augmenter la résistivité de l'épitaxie peut avoir des conséquences néfastes sur certains paramètres électriques des dispositifs actifs adjacents.

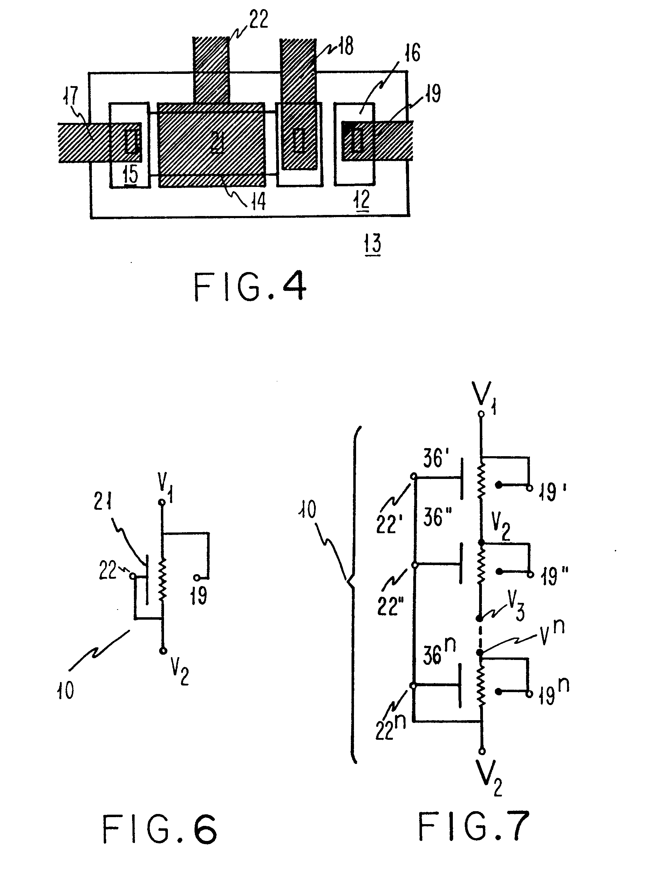

Une autre solution évidente consiste à réduire le développement de la couche d'appauvrissement dans la région résistive, ce qui diminue comme nous l'avons vu,

00006474

5

le développement de la valeur de la résistance. Cette réduction peut être obtenue en augmentant la dose d'ions implantés comme le montre l'article de J.W. Hanson: "Ion Implanted N Type Resistor on High Resistivity Substrates", J. Vac. Sci. Techn. Vol. 10, No.6, novembre, décembre 1973, et plus particulièrement à la figure 6 dudit article.

Encore une autre solution semble se dégager du brevet français No. 71 44227 (Philips NV). Bien qu'il ne soit à aucun moment explicitement mentionné, le VCR semble pouvoir être corrigé grâce à une implantation d'ions neutres dans la région résistive, de préférence dans le voisinage de la jonction PN. Ces ions générateurs de défauts cristallins ont la propriété d'améliorer la linéarité de la caractéristique courant-tension I-V de ladite résistance. On pourra plus particulièrement se reporter à la figure 7 dudit brevet. L'inconvénient majeur de ce procédé est qu'il nécessite une étape supplémentaire.

Encore une autre solution est décrite dans le brevet français No. 76 15001 déposé par la demanderesse le 13 mai 1976 et publié sous le No. 2 351 505. Dans son aspect le plus général, ce brevet décrit des moyens pour contrôler les variations de la différence de potentiel existant entre la région résistive et la couche épitaxiale, pour les réduire à un minimum. Pour cela on porte le potentiel de la couche épitaxiale à une valeur appropriée, qui est de préférence une tension qui varie de la même façon que la tension moyenne de la résistance à corriger. Si $V_1$ et $V_2$ sont les potentiels appliqués respectivement aux deux bornes de la résistance, la tension de l'épitaxie devra être de la forme

6

$$V_{epi} = \frac{1}{2} (V_1 + V_2) + V_0$$

où $V_0$ est un potentiel de polarisation continu. Avec cette valeur particulière de $V_{epi}$, la valeur de la résistance devient quasiment indépendante de la tension appliquée aux bornes de la résistance $V_R = V_1 - V_2$. Cependant ce procédé présente un grave inconvénient pour obtenir une compensation efficace: il est nécessaire de prévoir un circuit annexe qui applique à chaque lit épitaxique la valeur de polarisation qui lui convient. (On pourra se référer par exemple à la figure 4 de la demande de brevet précitée). Une telle solution, une fois intégrée, consomme de la surface sur la micro-plaquette, diminue la densité d'intégration. En outre les circuits annexes nécessaires peuvent ne pas présenter les performances souhaitables, en particulier la rapidité.

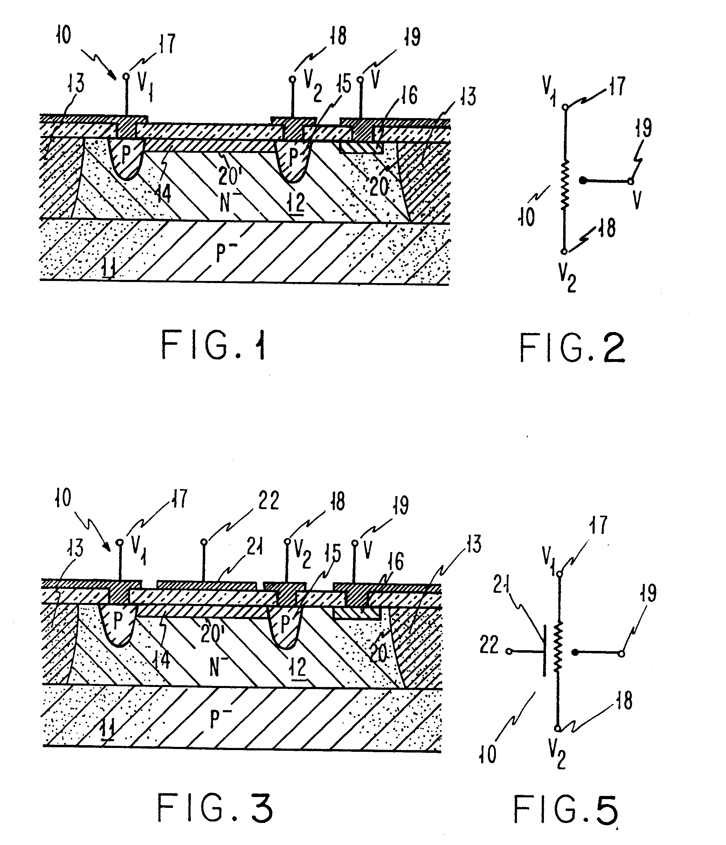

Dans ce même brevet, d'autres moyens de correction, qui ne prévoient pas l'utilisation de circuits annexes, sont également décrits (on pourra se référer aux figures 3B à 3D). Cependant ils n'apportent qu'une correction imparfaite du VCR.

Exposé de l'invention

Un premier objet de la présente invention consiste donc à proposer des moyens de correction du VCR de résistances implantées qui tolèrent des résistivités de la couche épitaxiale relativement faibles.

Un autre objet de l'invention est de fournir une résistance implantée aussi linéaire que possible quelque

7

soit la tension appliquée aux bornes de la résistance.

Un autre objet de la présente invention est de proposer des moyens de correction du VCR de résistances implantées qui ne nécessitent pas d'étapes de procédé supplémentaires.

Encore un autre objet de l'invention est de proposer des moyens de correction du VCR de résistances implantées qui ne nécessitent pas l'association auxdites résistances, de circuits annexes qui élaborent une tension appropriée de polarisation de la couche épitaxiale.

Encore un autre objet de l'invention est d'améliorer la performance des procédés déjà décrits dans le brevet précité No. 76 15001 et montrés sur les figures 3B à 3D, qui n'assurent qu'une correction imparfaite du VCR.

La présente invention décrit un procédé de correction du coefficient en tension d'une résistance semi-conductrice implantée, constituée par une région dite résistive d'un premier type de conductivité formée dans une couche isolée du type de conductivité opposé généralement une couche épitaxiale et passivée par une couche diélectrique, procédé caractérisé en ce qu'une couche métallique est formée sur ladite couche diélectrique et recouvre au moins partiellement ladite région résistive, que cette couche est portée à un potentiel approprié pour produire des variations dans la valeur de la résistance, égales et de sens contraire à celles créées par ladite couche épitaxiale pour assurer ainsi sa linéarité.

Dans une variante, la résistance sera fractionnée en plusieurs parties, auxquelles on appliquera le présent procédé.

D'autres objets, caractéristiques et avantages de la présente invention ressortiront mieux de l'exposé qui suit, fait en référence aux dessins annexés à ce texte, qui représentent un mode de réalisation préféré de celle-ci.

Brève description des figures

La figure 1 représente une vue en coupe schématique d'une résistance implantée typique et la figure 2 son schéma électrique équivalent.

La figure 3 représente une vue en coupe schématique de la résistance implantée de la figure 1 avec une électrode métallique disposée au-dessus de la région résistive, tandis que la figure 4 représente une vue de dessus de cette même résistance et la figure 5 représente son schéma électrique équivalent.

La figure 6 représente le schéma électrique d'une résistance implantée dont le VCR est corrigé conformément à la présente invention selon un premier exemple de réalisation.

La figure 7 représente le schéma électrique d'une résistance implantée dont le VCR est réduit d'une part par son fractionnement en plusieurs parties et d'autre part corrigé selon un second exemple de réalisation.

La figure 8 représente les variations $\frac{\Delta R}{R}$ en pourcentage

9

d'une résistance implantée (éventuellement scindée en plusieurs parties) en fonction de la tension appliquée à la couche épitaxiale, en l'absence d'une électrode métallique de correction du VCR.

La figure 9 représente les variations $\frac{\Delta R}{R}$ en pourcentage d'une résistance éventuellement scindée en plusieurs parties en fonction de la tension appliquée à la couche épitaxiale, en présence d'une électrode métallique de correction.

La figure 10 représente les variations $\frac{\Delta R}{R}$ en pourcentage d'une résistance scindée en cinq parties en fonction de la quantité de métal de recouvrement au-dessus de la région résistive.

## Description de l'invention

En se référant plus particulièrement à la figure 1, on a représenté une structure de résistance intégrée monolithique classique 10. Sur un substrat monocristallin semi-conducteur typiquement en silicium 11 d'un type de conductivité, par exemple $P^-$, on fait croître une couche épitaxiale 12 relativement mince: de l'ordre de quelques microns et peu dopée: de résistivité moyenne $1\Omega.cm$. Bien que la description fasse mention d'une couche épitaxiale l'homme de l'art comprendra que cette couche peut également être formée par diffusion, implantation ionique, etc. . Dans cette couche de type de conductivité opposé audit premier type, on définit une poche isolée par exemple grâce à des murs d'isolement 13 du premier type de conductivité et fortement dopés qui viennent rejoindre ledit substrat. On forme alors par implantation ionique d'une impureté du premier type

10

de conductivité, une région 14 de forme allongée destinée à servir de région résistive. Cette implantation peut être précédée de la formation de deux zones de contact de type P, référencée en 15, simultanément à la diffusion des bases des transistors bipolaires. Ces régions de contact assez fortement dopées, vis-à-vis de la région résistive proprement dite, assurent que la valeur de la résistance définie par la région résistive 14 ne sera déterminée que par la résistivité de feuille. Une seconde région 16, fortement dopée, du second type de conductivité, est généralement formée simultanément avec les régions émetteurs desdits transistors bipolaires pour servir de région de contact avec l'épitaxie. Des contacts ohmiques sont établis avec la résistance et la seconde région; ils sont représentés en 17, 18 et 19, respectivement. Les problèmes relatifs à la fabrication des résistances implantées sont bien connus dans la technique, on pourra trouver aisément des descriptions détaillées des procédés de fabrication. A ce titre, le brevet des E.U.A No. 3 902 926 est particulièrement significatif. On pourra également revoir l'article de J. Den Boer cité ci-dessus. Les bornes 17 et 18 sont portées aux potentiels $V_1$ et $V_2$ respectivement. La borne 19 qui assure le contact avec la couche épitaxiale (ou lit d'épitaxie) peut être soit non reliée (épitaxie flottante) ce qui n'est généralement pas souhaitable, soit reliée à un potentiel approprié, tandis que le substrat est porté au potentiel le plus négatif du circuit afin d'assurer la polarisation inverse de la jonction PN 20 formée entre le mur d'isolement et le substrat d'une part et la couche épitaxiale d'autre part. Cette polarisation en inverse garantit l'isolement électrique de la poche ainsi définie. On peut également préférer relier le point de

11

contact 19 au potentiel le plus positif du circuit, ce qui assure alors l'isolement électrique de la région résistive vis-à-vis de la couche épitaxiale. Ce dernier cas doit être nécessairement employé si plusieurs résistances sont formées dans une même poche épitaxiale. Ainsi, dans tous les cas grâce à la borne 19 on peut porter la couche épitaxiale à un potentiel désiré.

Sur la figure 2, on a représenté, le schéma électrique de la résistance implantée 10, les mêmes éléments portant les mêmes références. La valeur R de la résistance 10 peut être formée de la façon suivante, quand on ne tient compte que de l'influence de la couche d'appauvrissement sur le VCR:

$$R = Ro \ (1 + \lambda \ V_{eff}) \qquad\qquad (1)$$

où

Ro    est la valeur intrinsèque de la résistance déterminée par le matériau semiconducteur employé, et ses dimensions;

$\lambda$    est le VCR de la résistance dû à la couche d'appauvrissement, et

$V_{eff}$ peut être approché par la relation empirique

$$V_{eff} = V_{epi} - V_{RP} + k \ V_R \qquad\qquad (2)$$

avec

$V_{epi}$ représente le potentiel auquel est porté la couche épitaxiale,

- 12

$V_{RP}$ représente la valeur du potentiel le plus positif aux bornes de la résistance, ici par hypothèse $V_{RP} = V_1$,

$V_R$ représente la chute de potentiel au travers de la résistance soit $V_R = V_1 - V_2$ ($V_1$ et $V_2$ étant deux potentiels essentiellement variables), et

k est un coefficient dépendant essentiellement de la résistivité de feuille de la région résistive; l'expérimentation a montré que k était compris généralement entre 0,4 et 0,6. A titre d'approximation on peut prendre k=0,5. $V_{eff}$ et donc la valeur R de la résistance sont donc fonctions des tensions $V_1$ et $V_2$ essentiellement variables.

En faisant l'hypothèse que k=0,5, l'équation (1) devient en combinant avec (2):

$$R = Ro \ [1 + \lambda \ (V_{epi} - V_{RP} + 0,5 \ V_R)] \qquad (3)$$

Dans le brevet français précité No. 76 15001, l'objectif poursuivi est d'obtenir $V_{eff}$ égale à une constante, la valeur de la résistance sera alors indépendante des tensions appliquées $V_1$ et $V_2$. Ce résultat peut être obtenu si on applique à la couche épitaxiale qui contient le lit d'épitaxie de la résistance dont le VCR est à corriger, une tension obéissant à la loi générale:

$$V_{epi} = \frac{1}{2} \ (V_1 + V_2) + V_o \qquad (4)$$

13

$V_O$ est une tension seulement nécessaire pour polariser en inverse la jonction PN 20' formée entre la région résistive de type P et le lit de l'épitaxie de type N ainsi que la jonction 20, ainsi qu'on l'a vu ci-dessus. En introduisant $V_{epi}$ ainsi défini et $V_{RP} = V_1$ dans l'équation (3) on obtient:

$$R = Ro \ ( \ 1 + \lambda \ V_O)$$

On démontre ainsi que cette valeur particulière de $V_{epi}$ rend $V_{eff}$ indépendant de $V_R$, tension appliquée aux bornes de la résistance. La valeur de la résistance devient donc indépendante des tensions $V_1$ et $V_2$.

Cependant comme cela apparaît clairement sur les figures 3A et 4 du brevet français précité No. 76 15001, l'obtention d'une tension de polarisation égale à $\frac{1}{2}$ $(V_1+V_2)$ nécessite soit la présence d'un circuit image (figure 4) soit de circuits supplémentaires (figure 3A).

Une réalisation simplifiée est montrée sur la figure 3B de ce brevet. Il s'agit toujours de réduire les variations de la différence de potentiel entre la région résistive et la couche épitaxiale, mais à la différence des solutions représentées sur les figures 2 et 3A les variations de $V_{eff}$ sont réduites mais non annulées. Il s'agit comme cela apparaît sur la figure 3B de relier le point de contact 19 de l'épitaxie au potentiel le plus positif des potentiels $V_1$ et $V_2$ (par hypothèse on a choisi $V_1 > V_2$). En d'autres termes, au lieu d'appliquer une tension de la forme:

14

$$V_{epi} = \frac{1}{2}(V_1 + V_2) + V_o$$

on applique la tension $V_{epi} = V_1$. La relation (2) devient alors, avec $V_{RP} = V_1$ et $k = 0,5$:

$$V_{eff} = 0,5\ V_R$$

et la valeur de la résistance n'est plus une constante comme dans la relation (1) mais son expression devient de la forme:

$$R = R_o (1 + \frac{\lambda}{2} V_R)$$

elle augmente avec la tension appliquée aux bornes de la résistance. La correction du VCR, dans ce dernier cas, est donc très imparfaite, elle conduit cependant à diminuer le VCR de la résistance de façon significative. Cependant, cette solution est surtout valable dans le cas où la différence de potentiel aux bornes de la résistance $V_R$ est faible et où le mode commun $\frac{V_1 + V_2}{2}$ est élevé. Elle reste toujours intéressante par sa simplicité, mais ne peut être envisagée que dans l'hypothèse de signaux unipolaires qui vérifient l'inéquation $V_1 > V_2$.

Dans une autre réalisation simplifiée, explicitée dans le brevet français No. 76 15001 précité, la résistance 10 de valeur R a été scindée en deux parties 36' et 36", de valeur égale, isolées électriquement l'une de l'autre. La résistance 36' a son contact d'épitaxie 19'

15

relié à $V_1$ et la résistance 36" a son contact d'épitaxie 19" relié à

$\dfrac{V_1 + V_2}{2}$; on démontre également dans ce brevet que la valeur résultante de la résistance peut s'écrire:

$$R = R_o \left(1 + \frac{\lambda}{2}\ \frac{V_R}{2}\right)$$

on s'aperçoit que le partage de la résistance en deux parties égales permet de diviser par deux l'influence du coefficient de $V_R$ qui est $\lambda$, c'est-à-dire pratiquement le VCR. En généralisant, et en scindant la résistance R en n parties égales disposées chacune dans des poches électriquement isolées, c'est-à-dire que

$$R = \sum_{1}^{n} R_i$$

le VCR serait alors pratiquement divisé par n.

Pour plus de détails sur les calculs, on pourra se référer utilement à ce brevet français sus-mentionné. Tous ces modes de réalisation qui ont l'avantage d'être simples et de ne pas nécessiter d'étapes supplémentaires, présentent par contre l'inconvénient de n'assurer qu'une correction imparfaite du VCR.

Les inventeurs de la présente demande se sont aperçus que la linéarité d'une résistance implantée était également affectée par la présence d'une couche métallique disposée au-dessus de la région résistive. Ils sont donc arrivés à la conclusion, que le VCR était non seulement fonction de la différence de potentiel entre la couche épitaxiale et la région résistive, mais était

16

aussi influencé par la présence d'une électrode métallique disposée au dessus de la résistance.

On se référera maintenant à la figure 3 de la présente demande qui représente la même résistance implantée que celle représentée sur la figure 1 mais sur laquelle est figurée une électrode conductrice, typiquement en métal, 21 et munie d'un contact 22. Cette électrode apparaît clairement sur la figure 4 qui représente la vue de dessus de la résistance 10. Le schéma électrique équivalent de cette résistance est montré sur la figure 5.

On se souvient que la valeur de la résistance 10 était donnée par la relation (3)

$$R = Ro \quad [1 + \lambda \ (V_{epi} - V_{RP} + 0,5 \ V_R)] \ ou$$

$$R = Ro \quad [1 + \lambda \ (V_{eff})]$$

On démontre empiriquement que l'influence de la couche métallique sur la valeur de la résistance quand le métal est relié au potentiel le plus négatif, conduit à une relation du type

$$R = Ro \ [1-\sigma \ (-V_{met} + V_{RN} + 0,5 \ V_R)] \tag{5}$$

où

$\sigma$      est le VCR de la résistance dû à l'électrode de métal.

$V_{met}$ est le potentiel de l'électrode métallique, et

17

$V_{RN}$ le potentiel le plus négatif appliqué à la résistance. Dans un grand nombre d'applications ce sera le potentiel de la masse.

On a donc de façon similaire

$$(V_{eff})_{met} = -V_{met} + V_{RN} + 0,5 \, V_R$$

Quand une résistance implantée subit les deux effets, elle peut s'écrire:

$$R = Ro \quad [1 + \lambda \, (V_{epi} - V_{RP} + 0,5 \, V_R)]$$

$$[1 - \sigma \, (-V_{met} + V_{RN} + 0,5 \, V_R)]$$

dont le développement au premier ordre donne

$$R = Ro \, [1 + \lambda \, (V_{epi} - V_{RP} + 0,5 \, V_R)]$$

$$- \sigma \, (-V_{met} + V_{RN} + 0,5 \, V_R) \qquad (6)$$

ou encore

$$R = Ro \quad [1 + \lambda \, (V_{eff})_{epi} - \sigma \, (V_{eff})_{met}] \qquad (7)$$

Le principe de l'invention consiste donc à compenser les VCR; celui causé à la couche d'appauvrissement par celui causé par l'électrode métallique.

La condition d'une correction totale du VCR est donc

$$\lambda \, (V_{eff})_{epi} = \sigma \, (V_{eff})_{met}$$

18

## Premier exemple de réalisation

On se référera à la figure 6 qui représente la résistance implantée 10, dont l'électrode métallique est reliée au potentiel le plus négatif $V_2$, et dont le contact d'épitaxie est relié au potentiel le plus positif $V_1$, c'est-à-dire que

$$V_{RP} = V_1, \quad V_{RN} = V_2, \quad V_{epi} = V_1,$$

$$V_{met} = V_2 \text{ et } V_R = V_1 - V_2$$

Portons ces valeurs dans l'équation (6), on trouve:

$$R = Ro \quad [1 + 0,5 \ V_R \ (\lambda - \sigma)] \tag{8}$$

Il y a donc toujours une certaine compensation, qui peut être parfaite quand $\sigma = \lambda$; dans ce dernier cas la valeur de la résistance est égale à Ro quel que soit le courant qui la traverse. Cependant, en réalité $\sigma$ et $\lambda$ sont toujours différents, $\lambda$ étant généralement supérieur à $\sigma$.

## Second exemple de réalisation

On se référera à la figure 7. Sur cette figure, la résis-tance R a été fractionnée en n parties, formant n résistances élémentaires, R1 à Rn de valeurs indentiques et égale à $\frac{R}{n}$, pour la simplification de l'exposé.

D'après (6)

0006474

19

$$R_1 = \frac{Ro}{n} [1+\lambda \ (V_1-V_1+0,5 \ \frac{V_R}{n}) \ - \ \sigma \ (-V_2+V_2+0,5 \ \frac{V_R}{n}) \ ]$$

Soit

$$R_1 = \frac{Ro}{n} [1+0,5\lambda \ \frac{V_R}{n} \ - \ \sigma \ (-V_2+v_2+0,5 \ \frac{V_R}{n}) \ ]$$

de même

$$R_2 = \frac{Ro}{n} [1+0,5\lambda \ \frac{V_R}{n} \ - \ \sigma \ (-V_2+v_3+0,5 \ \frac{V_R}{n}) \ ]$$

et

$$Rn = \frac{Ro}{n} [(1+0,5\lambda \ \frac{V_R}{n} \ - \ \sigma \ (-V_2+V_2+0,5 \ \frac{V_R}{n}) \ ]$$

et

$$R = \sum_1^n R_i = \frac{Ro}{n} [n+0,5\lambda \ V_R \ - \ \sigma \ ( \ (1-n) \ V_2 \ ) \ + (v_2 + \ldots v_n) \ + \ 0,5 \ V_R \ ]$$

ce qui peut s'écrire:

$$\text{avec} \qquad v_2 + \ldots + v_n = \sum_2^n v_i = (n-1) \ V_2 + \frac{(n-1)(n)}{2} \ \frac{V_R}{n}$$

$$R = \frac{Ro}{n} [n + 0,5\lambda \ V_R \ - \ \sigma \ ( \ \frac{n}{2} \ ) \ V_R \ ]$$

$$R = Ro \ [ \ 1 + 0,5 \ ( \ \frac{\lambda}{n} \ - \ \sigma \ ) \ V_R \ ]$$

La compensation s'effectue pour

20

$$\frac{\lambda}{n} = \sigma \qquad\qquad (9)$$

on peut choisir n (nombre de résistances) et $\sigma$, qui est directement fonction de la quantité de métal qui recouvre la région résistive, pour que la correction s'effectue. En fait le métal ne peut pas recouvrir toute la région résistive pour des raisons de tolérances et de conception des circuits comme cela apparaît sur les figures 3 et 4.

Soit $\qquad \sigma = \dfrac{S_M}{S_R} \; \sigma_i \;$ ou encore $\; \sigma \leq \; 0{,}8 \; \sigma_i \qquad (10)$

relation dans laquelle $S_M$ est la surface de l'électrode métallique au-dessus de la région résistive, $S_R$ est la surface de cette dernière, et $\sigma_i$ le coefficient intrinsèque.

La relation finale est donc

$$\frac{\lambda}{\sigma_i} = \frac{S_M}{S_R} \cdot n$$

Dans une application typique 80% de cette surface au maximum a pu être recouverte (c'est le paramètre L qui est variable).

Cependant 100% de la partie implantée pourrait être recouverte si les parties diffusées 15, au cas où elles existent, étaient de longueur suffisante. Généralement il sera avantageux de viser un pourcentage inférieur au maximum pour permettre un ajustage final approprié aux paramètres exacts du procédé, et à

21

acquérir ainsi une souplesse supplémentaire dans la correction du VCR.

exemple: si $\lambda=4000$ ppm et $\sigma_i = 2000$ ppm, avec $\dfrac{S_M}{S_R} = 0,5$ qui sont des valeurs courantes, on trouve n=4.

Sur le plan pratique, l'électrode métallique se trouve réalisée lors de l'étape de photolithographie qui forme le premier niveau de métallurgie. L'invention se caractérise en ce qu'elle nécessite seulement une modification de ce masque, mais sans apporter d'étapes supplémentaires au procédé. Cependant on doit prévoir le découpage de la résistance en un nombre approprié de poches d'épitaxie individuelles. L'influence des facteurs n et

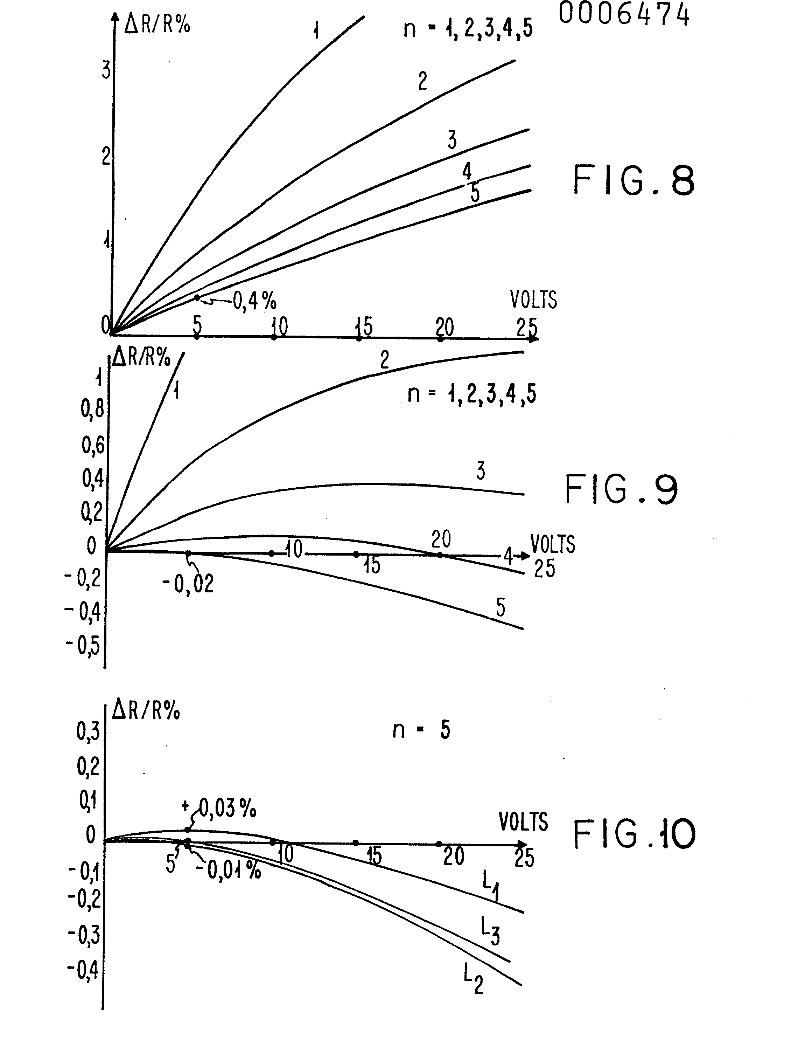

$\eta = \dfrac{S_M}{S_R}$ sur la correction du VCR va être ci-après étudiée en référence aux figures 8, 9 et 10.

Sur la figure 8, on a représenté (courbe 1) le taux de variation $\dfrac{\Delta R}{R}$ en % de valeur d'une résistance implantée dont une borne est reliée à la masse, et l'autre à un potentiel positif V qui est également appliqué au lit de l'épitaxie, en l'absence de l'électrode de correction 21. Ce même taux de variation a également été représenté lorsque la résistance a été scindée en plusieurs parties égales (courbes 2 à 5). Dans une application particulière où V = 5V et d'une résistance scindée en 5 parties, on trouve $\dfrac{\Delta R}{R} = 0,4\%$ (pour une résistance unique $\dfrac{\Delta R}{R} = 1,7\%$).

Les mesures ont été relevées sur des résistances fabriquées à partir d'un procédé (donc de paramètres de fabrication) déterminé. C'est ce même procédé qui a été mis en oeuvre pour les résistances représentées sur les figures 9 et 10.

Sur la figure 9 on a représenté le taux de variation $\frac{\Delta R}{R}$ en % des différents cas de résistances implantées montrés sur la figure 8 mais dans lesquels on a apporté la correction du VCR par la présence au-dessus des régions résistives, d'électrodes métalliques portées au potentiel le plus négatif (ici le potentiel de la masse).

Dans l'application mentionnée ci-dessus, pour $V_{epi} = 5V$ et n=5, on trouve alors $\frac{\Delta R}{R} = -0,02\%$. C'est-à-dire que si la différence de potentiel V appliquée à la résistance entre 0 et 5V, la variation maximale de la résistance sera de 0,02% x R. Le signe négatif indique qu'il y a une surcompensation.

Elle est déjà vingt fois plus petite que celle mesurée dans l'hypothèse de la figure 8.

Enfin pour montrer l'influence du facteur $\eta$ on pourra se référer utilement à la figure 10, qui représente dans l'hypothèse d'une résistance R fractionnée en 5 parties égales, les taux de variation $\frac{\Delta R}{R}$ en % en fonction du recouvrement de la région résistive par l'électrode de métal. Dans un cas particulier, chaque région résistive élémentaire de type P est un rectangle qui mesure 0,0625mm de long par 0,030mm de large. En appliquant la régle des 80% explicitée plus haut, la longueur de l'électrode métallique doit au plus être égale à 0,050mm. Avec n=5, on a représenté les résultats pour deux longueurs de l'électrode métallique $L_1 = 0,045mm$

23

et $L_2$ = 0,050mm. On se rend compte que pour n=5 et V=5V et $L_3$ = 0,049mm on obtient un taux de variation $\frac{\Delta R}{R}$ pratiquement nul, on peut dire dans ces conditions qu'une telle résistance est parfaitement corrigée en VCR.

On retiendra que la structure de résistance implantée munie d'une électrode métallique pour assurer la correction du VCR est différente, malgré d'apparentes similitudes, d'une résistance à effet de champ et à grille isolée du substrat, telle que celle qui est décrite dans le brevet français No. 1 566 559 déposé par la CSF le 20 mars 1968. En effet, dans la présente demande de brevet, la valeur de la résistance est déterminée par la résistivité de la région résistive, l'électrode métallique qui la recouvre n'a pour seule fonction que la correction du VCR. Tandis que dans la structure faisant l'objet du brevet CSF, l'électrode métallique est portée à potentiel tel, qu'elle modifie la résistivité de la zone de surface du substrat afin d'ajuster la résistance à la valeur désirée.

Les résistances implantées dont le VCR a été corrigé conformément au procédé de la présente invention peuvent trouver application notamment dans les circuits analogiques de commutation téléphonique, d'instrumentation électronique, de conversion analogique-numérique, etc. .

Bien que l'on ait décrit dans ce qui précède et représenté sur les dessins les caractéristiques essentielles de l'invention appliquées à un mode de réalisation préféré de celle-ci, il est évident que l'homme de

0006474

24

l'art peut y apporter toutes modifications de forme ou de détail qu'il juge utiles, sans pour autant sortir du cadre de ladite invention.

0006474

1

## REVENDICATIONS

1. Procédé de correction du coefficient en tension d'une résistance semi-conductrice constituée par une région dite résistive d'un premier type de conductivité formée dans une portion électriquement isolée d'une couche épitaxiale du type de conductivité opposé, portée à un potentiel déterminé, et passivée par une couche diélectrique, caractérisé en ce qu'une couche métallique est formée sur ladite couche diélectrique et recouvre au moins partiellement ladite région résistive, que cette couche métallique est portée à un potentiel approprié pour produire des variations dans la valeur de la résistance, égales et de sens contraire à celles créées par ladite couche épitaxiale pour assurer ainsi sa linéarité.

2. Procédé de correction selon la revendication 1 caractérisé en ce que ledit potentiel déterminé est celui de la plus positive des deux extrémités de la résistance.

3. Procédé de correction selon la revendication 2 caractérisé en ce que ledit potentiel approprié est celui de la plus négative des deux extrémités de la résistance.

4. Procédé de correction selon la revendication 1 caractérisé en ce que ladite résistance est scindée en n résistances élémentaires disposées dans des portions de la couche épitaxiale, isolées électriquement les unes des autres, chaque portion

2

étant portée à un potentiel déterminé et chaque
électrode à un potentiel approprié.

5. Procédé de correction selon la revendication 4
caractérisé en ce que toutes les électrodes sont
portées à un même potentiel qui est le potentiel
de la plus négative des deux extrémités de ladite
résistance.

6. Procédé de correction selon la revendication 5
caractérisé en ce que ledit potentiel déterminé
auquel est portée chaque portion est celui de la
plus positive des deux extrémités de la résistance
qu'elle contient.

7. Procédé de correction selon l'une quelconque des
revendications ci-dessus caractérisé en ce que
le coefficient $\eta$ caractéristique de la quantité de
recouvrement par du métal de la région résistive
est ajusté pour obtenir une correction parfaite du
VCR.

8. Procédé de correction selon l'une quelconque des
revendications ci-dessus caractérisé en ce que
ladite région résistive est formée par implantation ionique.

FIG.1

FIG.2

FIG.3

FIG.5

0006474

FIG.4

FIG.6

FIG.7

0006474

FIG.8

FIG.9

FIG.10

## DOCUMENTS CONSIDERES COMME PERTINENTS

| Catégorie | Citation du document avec indication, en cas de besoin, des parties pertinentes | Revendication concernée |
|---|---|---|
| X | PATENT ABSTRACTS OF JAPAN, vol. 1, no. 44, 27 avril 1977, page 2714E76 <br><br> & JP - A - 51 140581 <br><br> -- | 1 |
| | US - A - 4 072 868 (F.H. DE LAMONEDA et al.) <br>    * Figure 2; colonne 3, ligne 62 - colonne 5, ligne 7 * <br><br> -- | 1 |
| | FR - A - 1 563 533 (NATIONAL RESEARCH DEVELOPMENT CORPORATION) <br>    * Figure 5; page 10; lignes 22-42 * <br><br> -- | 1 |
| | US - A - 4 001 612 (T. AOKI et al.) <br>    * Figures 1-2; revendications * <br><br> -- | 1 |
| E | DE - A - 2 902 494 (WESTERN ELECTRIC) <br>    * Figures 1-3; revendications * | 1,8 |
| E | & FR - A - 2 415 878 <br><br> ---- | |

**CLASSEMENT DE LA DEMANDE (Int. Cl.³)**

H 01 L 27/08
H 01 L 29/86

**DOMAINES TECHNIQUES RECHERCHES (Int. Cl.²)**

H 01 L 27/08
H 01 L 29/86
H 01 L 29/10

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons

&: membre de la même famille, document correspondant

Le présent rapport de recherche a été établi pour toutes les revendications

| Lieu de la recherche | Date d'achèvement de la recherche | Examinateur |
|---|---|---|
| La Haye | 24-09-1079 | CARDON |

OEB Form 1503.1  06.78